# EUROPEAN PATENT APPLICATION

(11) **EP 0 606 648 A2**
(43) Date of publication of application: **20.07.1994**
(21) Application number: 93121022.3
(22) Date of filing: 28.12.1993
(51) Int. Cl.: H01L 21/56, B29C 33/72

(54) **Semiconductor manufacturing apparatus and method of manufacturing semiconductor device**

(30) Priority: 15.01.1993 JP 21739/93
(71) Applicant: KABUSHIKI KAISHA TOSHIBA, Kawasaki-shi, Kanagawa-ken 210 (JP)
(72) Inventor: Egashira, Mika, c/o Intellectual Property Div., Minato-ku, Tokyo 105 (JP); Noda, Yasumasa, c/o Intellectual Property Div., Minato-ku, Tokyo 105 (JP); Takei, Shinji, c/o Intellectual Property Div., Minato-ku, Tokyo 105 (JP)
(74) Representative: Lehn, Werner, Dipl.-Ing.

(57) **Abstract**

In a semiconductor manufacturing apparatus, a cleaner (2) is inserted in a space defined between an upper mold (1) and a lower mold (3), which are incorporated in a mold unit. The cleaner (2) has an ultraviolet-ray supply unit (26, 27), an ozone supply unit (28), an ozone collecting unit (29), and a brush. Dirt on the surfaces of the upper and lower molds is decomposed and removed by radiating ultraviolet rays in the atmosphere of heated ozone.

## Description

This invention relates to a semiconductor manufacturing apparatus capable of automatically cleaning a mold, and to a method of manufacturing a semiconductor device.

A technique for protecting semiconductor elements incorporated in a semiconductor device, such as an IC and an LSI, includes a technique for sealing semiconductor elements with an organic material, e.g. a synthetic resin. Resin sealing members are suitable for mass production, and can be made at low cost, and hence are employed in many semiconductor devices.

Although a potting method effected without using a mold is known as one of sealing methods using a resin, transfer molding which uses a mold has recently been employed in many cases. In this method, a lead frame, on which a chip to be sealed is placed, is set in a lower cavity of a mold unit (consisting of lower and upper molds) heated beforehand to a predetermined temperature, and then an upper cavity of the mold unit is closed. A resin member shaped like a tablet is preheated by means of a high frequency preheater so as to increase its fluidity in the mold unit, and is then injected into a pot, where a transfer plunger is operated to inject the heated resin into cavities through a runner and a gate. Thus, the injected resin is pressurized to have a shape.

The pressure molding is performed for 1 - 3 minutes under a pressure of 20 - 100 kg/cm² until the resin is hardened to some extent. The number of cavities is determined on the basis of the size of each cavity, and selected from a group consisting of one - several hundreds. When the resin has been hardened to such an extent as enables the resin to be taken out of the cavity, the mold unit is opened, and a product is separated from the cull runner and then subjected to post curing, debarring, plating, cutting, etc. Thereafter, the product is examined and marked. The resin to be used for molding may be a thermosetting resin or a thermoplastic resin; for example, an epoxy resin, silicone, a silicone-epoxy resin, a polyacetal resin, a polyimide resin, etc.

In general, in the case of sealing a semiconductor element with a resin by the use of a mold unit, injection molding or transfer molding is performed. Gases, which are generated during the molding, are caked and stuck to the mold unit while the molding is repeated. Further, compounds contained in the resin or a releasing agent are deposited and stuck to the mold unit. These stuck substances may reduce the accuracy in the size of a molded product, or may be stuck to the product, thereby damaging its appearance, or may make it hard to release the product from the mold unit. To avoid this, cleaning of the mold unit is an indispensable process in manufacturing semiconductor devices.

There are various cleaning methods at present -- a method of removing stuck substances by the use of cloth or absorbent cotton after applying cleaning solvent onto a mold unit; or a method of filling a mold unit with a melamine resin in a known manner after applying a cleaning solvent onto a mold unit, thereby removing stuck substances. In these methods, however, the detergency of the cleaning solvent is low; and the stuck substances are wiped manually, which requires substantial labor and time. In general, a mold unit has to be stopped every 500 - 1000 shots, and be subjected to 2 - 4 hour cleaning. Further, it has been indicated that a complicated mold unit for fine molding is hard to completely wipe every corner in a manual manner.

As explained above, in the conventional cleaning, the continuous operation of the mold unit is once stopped, and a resin is filled in the mold unit to remove substances stuck thereto. However, it has been indicated that the cleaning resin may well crack after molding, and that the molding process including cleaning is hard to perform without man power.

Furthermore, in molding a product, molding must be performed with the use of a release recovery resin, a dummy product must be molded, or it must be confirmed whether or not the mold unit is in a good releasing state.

In addition, a technique for decomposing and removing substances stuck to a mold unit by radiating ultraviolet rays onto the substances is known e.g. from Jpn. Pat. Appn. KOKAI Publication No. 60-250915. Ozone, which can be created from oxygen in the air by radiating ultraviolet rays onto oxygen with the use of a low voltage mercury lamp, has a chemical function for auxiliarily decomposing stuck substances. However, the amount of ozone obtained from the disclosed lamp is 300 ppm at most. Therefore, a remarkable cleaning effect cannot be obtained from the lamp, and a cleaning temperature is not clarified in the publication.

The present invention has been developed in light of the above circumstances, and its object is to provide a semiconductor manufacturing apparatus and a manufacturing method employed in the apparatus, which is capable of performing a mold process, including the process of cleaning a mold unit without man power and hence in a short time to thereby effectively remove dirt stuck to the surfaces of the mold unit.

To attain the object, the semiconductor manufacturing apparatus of the invention comprises:
mold means provided with an upper mold and a lower mold for sealing a semiconductor chip with a resin; and
removal means for decomposing and removing dirt on the surfaces of the upper and lower molds by radiating ultraviolet rays in the atmosphere of heated ozone.

Further, the method of manufacturing a semiconductor device comprises the steps of:
heating a mold unit consisting of upper and lower molds;
decomposing and removing dirt on the surfaces of the upper and lower molds by radiating ultraviolet rays in the atmosphere of heated ozone;
clamping the upper and lower molds after placing in the lower mold a lead frame having a semiconductor chip mounted thereon;
injecting a melted resin into the mold unit;
hardening the injected resin; and
dismounting the lead frame from the mold unit.

The semiconductor manufacturing apparatus and manufacturing method constructed as above can omit the process of manually removing stuck substances and hence save substantial labor and time. Moreover, the cleaning effect of the apparatus is so remarkable that every corner of even a complicated mold unit to be used for fine molding can be cleaned.

This invention can be more fully understood from the following detailed description when taken in conjunction with the accompanying drawings, in which:
FIG. 1 is a front view of a semiconductor manufacturing apparatus according to the invention, showing a state in which a cleaner is mounted therein;
FIG. 2 is a schematic partial front view of the semiconductor manufacturing apparatus according to the invention, showing a state assumed when a semiconductor device is molded without the cleaner;
FIG. 3 is a plan view, showing a parting surface of a lower mold of the invention;
FIG. 4 is a view of an arrangement of the invention, in which the units of a cleaner main body inserted between lower and upper molds;
FIG. 5 is a view of another arrangement of the invention, in which the cleaner main body is provided outside molds and connected thereto by means of a pipe, etc.;
FIG. 6 is a view of the cleaner main body of the invention, taken along lines VI - VI of FIG. 1;
FIG. 7 is a view of the cleaner main body of the invention, taken along lines VII - VII of FIG. 1;
FIG. 8 is a plan view of an example of a cleaner main body of the invention, showing a tip end portion thereof;
FIG. 9 is a graph, useful in explaining the cleaning effect of the invention, and showing the relationship between an optical reflectance improvement ratio and the density of ozone;
FIG. 10 is a graph, useful in explaining the cleaning effect of the invention, and showing the relationship between the optical reflectance improvement ratio and an ultraviolet-ray radiation time;
FIG. 11 is a graph, useful in explaining the cleaning effect of the invention, and showing the relationship between the optical reflectance improvement ratio and a treatment temperature;
FIG. 12 is a flowchart, useful in explaining an example of a semiconductor manufacturing method according to the invention; and
FIG. 13 is a plan view, useful in explaining one step of the semiconductor manufacturing method of the invention.

The embodiments of the invention will be explained with reference to the accompanying drawings.

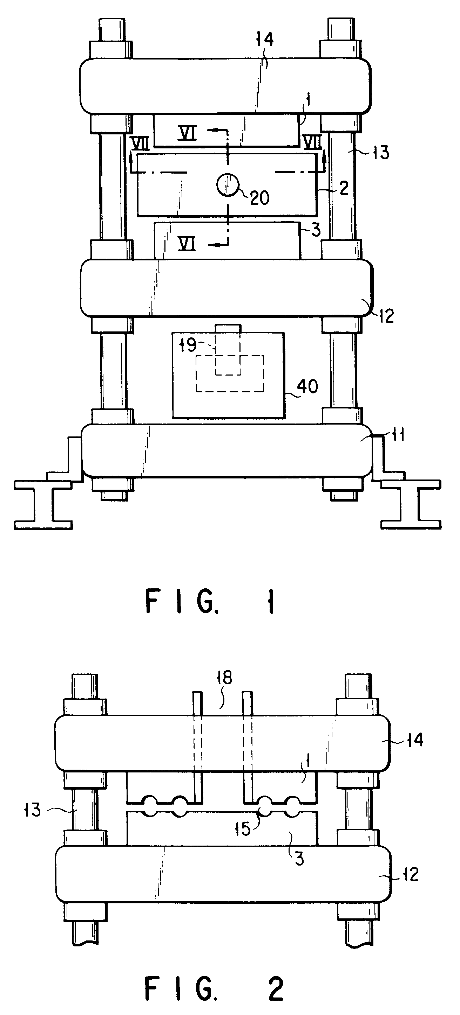

FIG. 1 shows a mold unit employed in a semiconductor manufacturing apparatus of the invention. Like the conventional one, this mold unit has upper and lower molds 1 and 3 for sealing, by means of resin molding, a lead frame, etc., to which a semiconductor chip is attached. A lower platen 11 supports the upper and lower molds. A mold clamping unit 40 as driving means is interposed between the lower platen 11 and a movable platen 12. A piston rod 19 extends in and projects from the clamping unit 40 such that it can move in the vertical direction, and supports the movable platen (slide base) 12. The movable platen 12 can move up and down along a plurality of tie bars 13 projecting from the lower platen 11. The lower mold 3 is secured to the upper surface of the movable platen 12, and faces the upper mold 1. The upper mold 1 is secured to the lower surface of the upper platen 14, which is secured to the upper ends of the tie bars 13. Resin molding is performed between the upper and lower molds 1 and 3. After the molding, the resultant product is dismounted from the molds, and a cleaner 2 is inserted between them to remove resin still stuck on the surfaces of the molds, thus preparing the molds for the next molding.

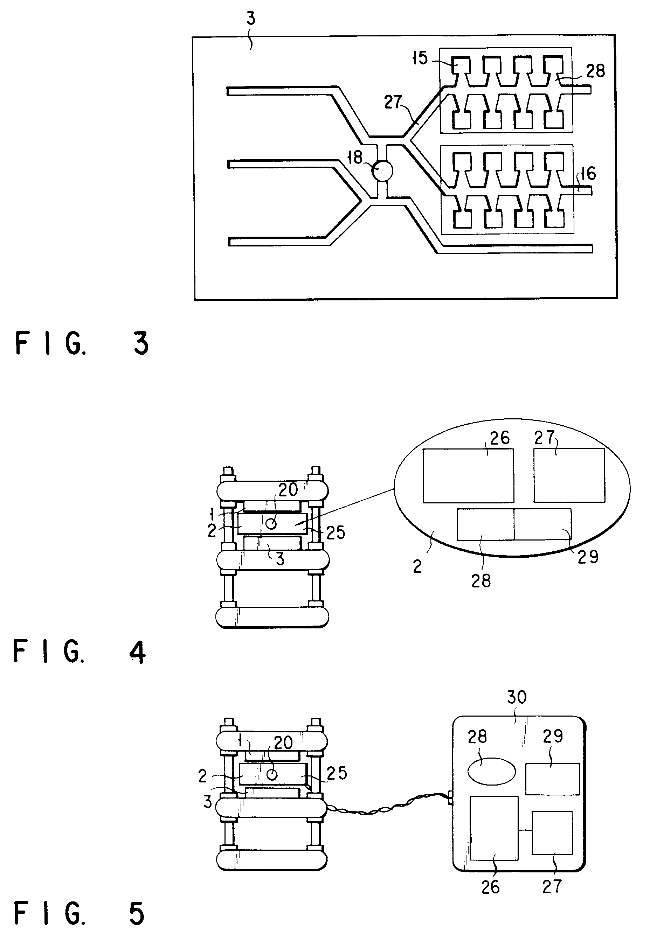

FIG. 2 is a schematic partial plan view, useful in explaining detailed portions of the mold unit for performing transfer molding, and showing no cleaner. FIG. 3 is a plan view, showing that parting surface between the lower mold 3 and the upper mold 1. In the parting surface of the lower mold 3 which faces and contacts the upper mold 1, a pot 18 is provided at the center, and a plurality of pairs of cavities 15 facing one another are provided in each block. A plurality of main runners 27 diverging from a cull portion of the pot 18 communicate with a sub-runner 16. The cavities 15 communicate with the sub-runner 16 through gates 28. FIG. 2 schematically shows the pot 18 and the cavities 15 communicating therewith. Although in this embodiment, a single pot is employed in the molds, a plurality of pots may be formed in the molds.

A semiconductor chip is placed on the parting surface of the upper and lower molds 1 and 3 of the transfer-molding-type mold unit, and a lead frame bonded by means of a bonding wire, etc. is set, thereby performing clamping. Thereafter, a synthetic resin such as a semiconductor-sealing epoxy mold resin or a polyimide resin, which is preheated and shaped like a tablet, is injected into a cylindrical pot 18 provided in a central portion of the upper mold 1, and is pressurized by means of a cylindrical plunger from above. The resin, which has been fluidized by pressurizing and heating, is pressure-injected into the cavities 15 through the main runners, the sub-runner, and the gates, and is molded with the semiconductor chip sealed therein. The molded lead frame is dismounted from the molds, and then post-cured in an oven. Thereafter, the unnecessary resin stuck to the surface of the lead frame is removed, thereby performing packaging and lead molding to complete the product. On the other hand, the parting surface of the molds must be cleaned so as to perform the next molding, such that the unnecessary resin stuck to the surface thereof is removed while a mold-releasing agent coated on the surface remains as it is. At this time, the mold releasing agent (e.g. wax) which is extracted as a result of first several tens shots must be kept, and the unnecessary resin stuck to the molds as a result of shots after the first shots must be removed. To this end, as is shown in FIG. 1, the cleaner 2 is inserted between the upper and lower molds 1 and 3 which are separated from each other, to clean the surfaces of the molds.

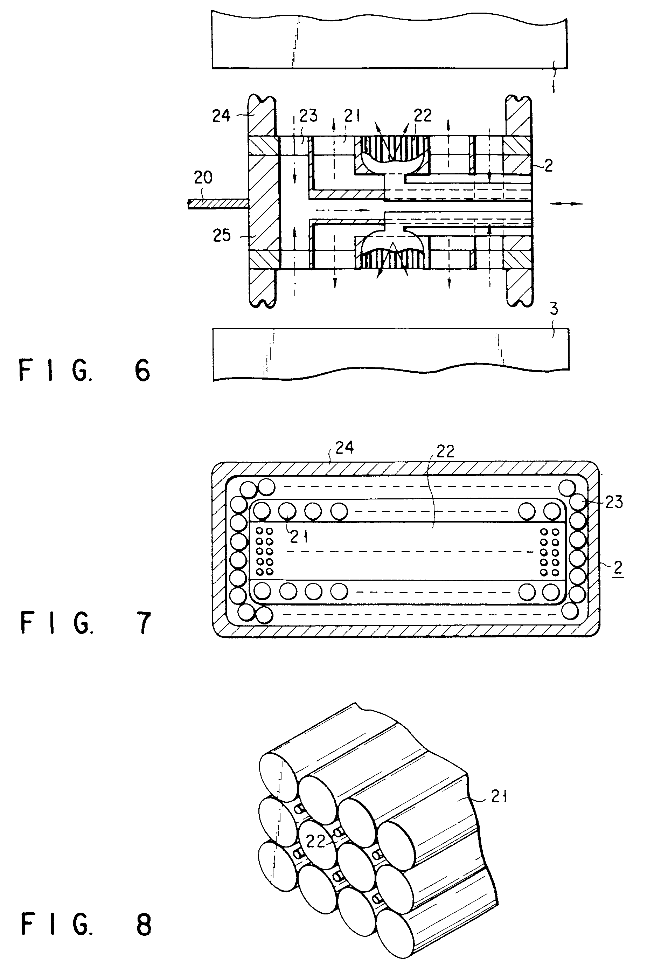

Then, the internal structure of the cleaner 2 will be explained with reference to FIGS. 4 - 8.

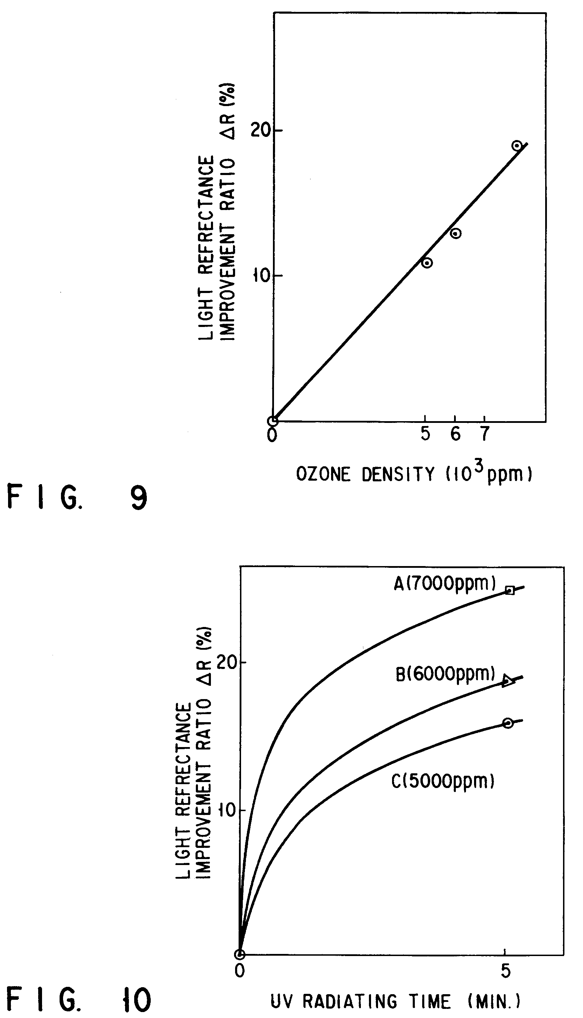

FIG. 4 shows units contained in the cleaner main body inserted between the upper and lower molds of the molding apparatus, and FIG. 5 the cleaner main body provided outside the molds and connected thereto by means of a pipe. FIGS. 6 and 7 are cross sectional views, taken along lines VI - VI and lines VII - VII, respectively. The cleaner 2 can be moved on the surfaces of the molds by means of an arm 20 attached to at least one side thereof. The cleaner 2 has at least a brush, an ultraviolet radiation generator, an ozone generator, and an ozone collecting device for eliminating ozone by reduction, etc. and collecting exhausted gases. If necessary, the cleaner 2 may include an ozone heater and a lower mold heater. FIG. 4 shows a case, where all units are housed in the body of the cleaner 2, which is moved between the molds 1 and 3. These units include an ultraviolet (UV) lamp 26, a UV power source 27, an ozone generator 28, and an ozone collector (ozone reducing device) 29. FIG. 5 shows a case, where the main body 30 of the cleaner is located outside the molds 1 and 3, and only a brushing portion including a brush is inserted between the molds and serves as the cleaner 2. The brushing portion is connected to the cleaner main body 30 via a wire consisting of a glass fiber for radiating ultraviolet rays, an ozone supply pipe, and an ozone collecting pipe, etc.

Thus, only the power source cable extends to the outside from the cleaner 2 positioned between the molds in the case of FIG. 4, whereas the glass fiber, and the ozone supply and collecting pipes as well as the power source cable are positioned outside the molds and connected to the cleaner main body in the case of FIG. 5. The cleaner main body 30 has the UV lamp 26, the UV power source 27, the ozone generator 28, and the ozone collector (ozone reducing device) 29. Referring to FIG. 6, the structure of the cleaner 2 will be explained more in detail, using the case of FIG. 5 where the brushing portion is separated from the cleaner main body 30. The cleaner 2 has a rectangular frame 25 and brushes 24 are planted for brushing the surfaces of the molds. An arm 20 is fixed to a side surface of the frame 25, for moving the cleaner 2 in the molds. One side of the cleaner 2 has substantially the same length as one side of each mold. Thus, only linearly moving the cleaner 2 can clean the overall surfaces of the molds when the corresponding sides of the cleaner 2 and the mold are aligned with each other. It is not always necessary to make the shape of the cleaner surface identical to that of the mold surface. In the case of the cleaner 2 shown in Fig. 1, one side thereof is a little larger than that of each mold, and hence it suffices if the cleaner 2 is moved only in the vertical direction. In the cleaner 2, two bunches of ozone supply pipes 22 extend from the ozone (O₃) generator and face the upper and lower molds 1 and 3, respectively.

Further, tip portions of two bunches of glass fibers 21 face the molds for radiating ultraviolet rays onto the surfaces of the molds. As is shown in Fig. 7, the ozone supply pipe bunches 22 are interposed between the glass fiber bunches 21. Ozone collecting pipes 23 for collecting ozone or exhausted gases are formed inside the brushes 24 and surround the glass fiber (or optical guide pipe) bunches 21 and the ozone supply pipe bunches 22. The bunches 21, 22, and the pipes 23 extend through one side of the frame 25 to the outside cleaner main body 30. Although a heater for heating the molds can be attached to the cleaner 2 thus constructed, the heater is not usually used. Further, since heating can much activate ozone as explained below, a heater may be attached to the ozone generator or the ozone supply pipe. Thus, in order to eliminate a substance stuck to the mold surfaces, such as resin, it is indispensable to radiate ultraviolet rays onto the surfaces of the molds at a high temperature in the atmosphere of ozone. If the density of ozone or the amount of UV radiation varies on the surfaces of the molds, a sufficient cleaning effect cannot be obtained.

To avoid such variations, a tip portion of the cleaner 2 can be modified as shown in FIG. 8. Specifically, glass fibers 21 are arranged in columns and rows, and ozone supply pipes 22 having a diameter smaller than the glass fibers are inserted between adjacent glass fibers 21. This arrangement enables ozone and UV radiation to be applied simultaneously and uniformly to the overall mold surface. Since not ozone itself but an oxygen radical, which is created during composition/decomposition of ozone, has a cleaning function, as will be explained later. Decomposition of ozone is performed by UV radiation, and accordingly ozone can effectively be decomposed when the glass fibers are located in the vicinity of the ozone supply pipes.

The cleaning properties of the semiconductor manufacturing apparatus of the invention will now be explained.

The process of manufacturing a semiconductor device includes several cleaning steps. Whether or not sufficient cleaning has been performed in these steps greatly influences the yield of products and/or the manufacturing efficiency. The semiconductor manufacturing apparatus of the invention has been devised in light of the above, and the cleaner incorporated in the apparatus has an improved structure for decomposing a substance (such as a resin) stuck to the mold surface and heated, by radiating UV rays onto the surface in the atmosphere of ozone, so as to remove the substance. It is known that UV rays and ozone are effective against organic contamination, and in the invention, cleaning using UV rays and ozone (UV/ozone cleaning) is applied to molds and the semiconductor manufacturing process using the molds. More specifically, decomposition of a carbohydrate with the use of UV rays is a known technique. Oxygen is converted to ozone as a result of UV radiation, during which an oxygen radical is created.

Further, ozone is decomposed when it receives UV radiation, thereby creating the oxygen radical. This oxygen radical performs strong oxidation and decomposes an organic compound.

Quite recently, researches for cleaning performed with the use of UV rays in the atmosphere of ozone has been started. It is the principle of the UV/ozone cleaning to supply a great amount of ozone so as to create a great amount of an oxygen radical, and then to decompose an organic compound into volatile substances, such as water, carbonic acid gas, and nitrogen gas, by the UV radiation and strong oxidation with ozone and the oxygen radical, so as to remove the organic compound from the surface of a mold. To create ozone, a usual ozone generator is employed, which creates ozone of several tens of thousands ppm or more by applying a high voltage between electrodes existing in the atmosphere of an oxygen. Although UV rays radiated from a low voltage mercury lamp can decompose oxygen, the density of ozone created by the lamp is as low as about 300 ppm, and hence the lamp is not suitable to the manufacturing apparatus of the invention. Here, note that 1g/m³ of ozone is 510 ppm. The UV radiation used in the invention has a wavelength of 100 - 450 nm, and a hydrogen discharge tube, a xenon discharge tube, a mercury lamp, or a germicidal lamp can be used as an ozone generator.

The wavelength of the UV radiation is limited to values, at which ozone and the oxygen can absorb the radiation. If the wavelength is equal to or longer than 450 nm, ozone and oxygen are hard to decompose, while if the wavelength is equal to or shorter than 100 nm, a releasing agent (e.g. wax) to be coated on the mold surfaces in the molding process, can be decomposed, as well as ozone and oxygen. The most effective wavelength of the UV radiation is about 242.4 nm at which oxygen creates the oxygen radical, and 310.0 nm or less at which ozone creates the oxygen radical. Since the UV absorption peak of ozone at the time of decomposition thereof appears when the UV radiation has a wavelength of about 250 nm, a bright line of 253.7 nm of a low voltage mercury lamp is effective. In the case of using a low voltage mercury lamp, the input density is 0.5 - 10 W/cm, and the lamp input is 4 - 1000 W.

Then, a cleaning effect of ozone to the mold surface will be explained with reference to FIG. 9.

FIG. 9 shows the dependency of the cleanness of the mold surface on the density of ozone. The axis of ordinate indicates an optical reflectance improvement ratio Δ R (%), and the axis of abscissa the density (10³ ppm) of ozone. The optical reflectance improvement ratio &$ R is equal to R - R0, where R0 represents the reflectance of the mold surface obtained when the surface is not subjected to a cleaning treatment after being subjected to a molding treatment, and R the reflectance of the mold surface obtained when the surface is subjected to the cleaning treatment. UV radiation is performed at 180°C for about 5 minutes, using a low-voltage mercury lamp of 1,000 W. When a resin is stuck to the mold surface, the resin absorbs light and hence reduces the optical reflectance improvement ratio Δ R of the mold surface. After the stuck organic substance or resin is decomposed by UV radiation and ozone applied thereto, the optical reflectance improvement ratio Δ R increases. Although in FIG. 9, the ozone density of 5,000 - 7,000 ppm is indicated, ozone of a density of up to about 100,000 ppm can be used in the invention. In order to keep the ozone density at a predetermined value, ozone must be supplied on a continuous basis through the ozone supply pipe so as to compensate for ozone decomposed by UV radiation. When ozone is excessively supplied, it is collected by the ozone collecting pipes and decomposed. The decomposed ozone, i.e., oxygen, is again supplied together with ozone in the UV radiation process.

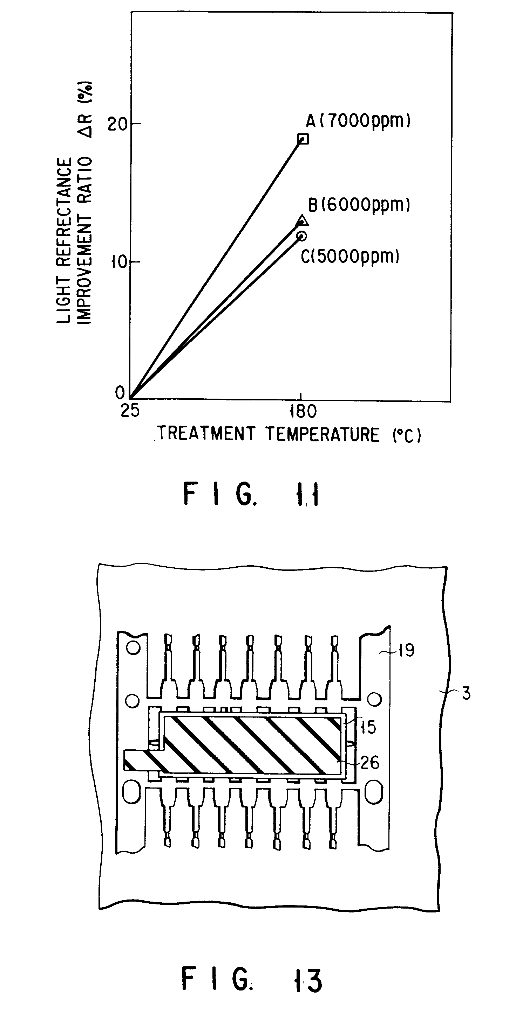

Since the ozone collecting pipes simultaneously collect gases and/or organic particles created when an organic substance stuck to the mold surface is decomposed, the interior of the cleaner can be kept clean, thereby significantly enhancing the cleaning effect thereof. Then, the dependency of the cleanness of the mold surface on the UV radiation time period, which appears where the ozone density is constant, will be explained with reference to FIG. 10. The axis of ordinate indicates the optical reflectance improvement ratio Δ R (%), and the axis of abscissa the UV radiation time period (minutes). As in the case of FIG. 9, UV radiation is performed at 180°C by the use of a low voltage mercury lamp of 1000 W. Where constant UV radiation conditions are set, the cleaning effect depends upon the ozone density, and the dependency does not change after 5 minutes elapses. This means that the cleaning effect is greatly influenced by the ozone density. In FIG. 10, line A indicates a case where the ozone density is 7,000 ppm, line B a case where the ozone density is 6,000 ppm, and line C a case where the ozone density is 5,000 ppm. Then, referring to FIG. 11, the dependency of the cleanness of the mold surface on the cleaning temperature, which appears where the ozone density is constant, will be explained. The axis of ordinate indicates the optical reflectance improvement ratio Δ R (%), and the axis of abscissa the treatment temperature. Almost no cleaning effect is found at 25°C, whereas at 180°C an organic substance is activated and the optical reflectance improvement ratio Δ R (%) is increased. The temperature range suitable to the cleaning is about 150 - 200°C.

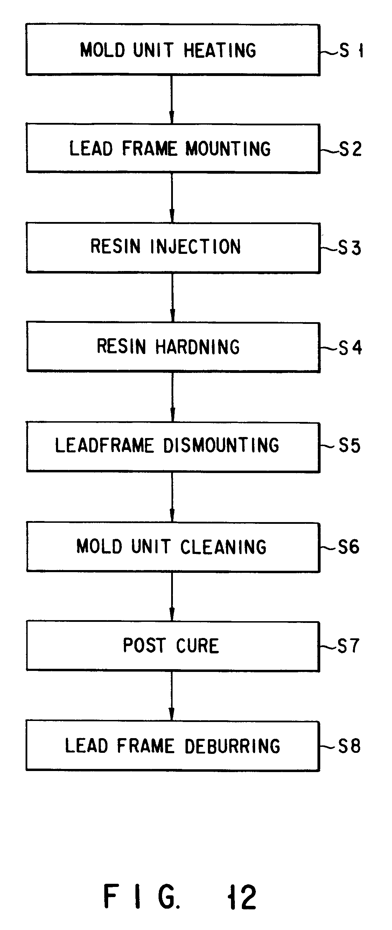

Referring to FIGS. 12 and 13, the semiconductor manufacturing process performed in the semiconductor manufacturing apparatus of the invention will be explained. FIG. 12 is a flowchart, useful in explaining the manufacturing process, and FIG. 13 is a plan view, showing the lower mold of the apparatus and a lead frame placed on the lower mold and provided with a semiconductor chip sealed with a resin by resin molding. This resin molding is performed in the manner shown in FIG. 12. First, the mold unit consisting of the upper and lower molds 1 and 3 are heated to about 180°C (step S1). Then, the mold unit is opened, and a lead frame 19 having a semiconductor chip mounted thereon is placed in the cavity 15 of the lower mold 3 (step S2). A resin tablet is inserted into a pot in the mold unit, where the resin is melted under high pressure. The melted resin 26 is injected into the cavity 15 to seal the semiconductor chip, bonded on the lead frame 19 by means of a bonding wire, and its periphery (step S3). This state is shown in FIG. 13. The melted resin 26 is hardened (step S4). Then, the lead frame is dismounted from the mold unit (step S5). Thereafter, the mold unit is opened, and the cleaner of the invention is inserted, by means of its arm, between the upper and lower molds with the distance between the upper and lower molds kept constant, thereby applying UV radiation and ozone to the surfaces of the molds to remove remaining resin (step S6).

Subsequently, the lead frame dismounted from the mold unit is put into an oven, where the resin sealing the frame is post-cured at about 175°C for about 8 hours (step S7). The post curing is performed preferably at 160 - 200°C for 3 - 10 hours. While the lead frame is treated in the oven, the glass fiber and ozone supply pipe of the cleaner are inserted into the oven, thereby applying UV radiation and ozone to the lead frame 19 for several tens minutes - one hour to thereby decompose and remove a resin flash (or burr) formed in the vicinity of the tie bars of the frame (step S8). Since it suffices if UV radiation and ozone are applied only to that portion of the lead frame on which the resin flash is formed, an arrangement other than that shown in FIG. 8 may be employed, in which the glass fiber bunches and the ozone supply bunches are arranged such that only the portion on which the resin flash is formed is supplied with the UV radiation and ozone. Further, although in the step S8, the cleaner used in the step S6 can be used as the UV/ozone supply means, another cleaner may be employed.

In any case, it is preferable to use a cleaner as shown in FIG. 5, i.e., a cleaner which has UV supply means and ozone supply means separate from the cleaner main body. Moreover, inserting only the UV/ozone supply means between the upper and lower molds of the mold unit enables the resin flash to be removed in a state where the lead frame is placed in the mold unit. In addition, since the remaining heat of the molding process is utilized also in the cleaning process, it is not always necessary to attach a particular heating device to the cleaner. However, attaching the heating device to the ozone supply device of the cleaner so as to blow heated ozone can further enhance the cleaning effect.

## Claims

1. A semiconductor manufacturing apparatus characterized by comprising:
mold means (1, 3) provided with an upper mold (1) and a lower mold (3) for sealing a semiconductor chip with a resin; and
removal means (26, 27, 28, 29) for decomposing and removing dirt on the surfaces of the upper and lower molds by radiating ultraviolet rays in the atmosphere of heated ozone.

2. The semiconductor manufacturing apparatus according to claim 1, characterized in that the removal means has cleaner means (2) to be inserted between the upper and lower molds (1, 3) for cleaning the surfaces of the upper and lower molds, the cleaner means (2) having ultraviolet-ray supply means (26, 27), ozone supply means (28), ozone collecting means (29) for collecting ozone and exhausted gases, and a movable brush to be brought into contact with the upper and lower molds.

3. The semiconductor manufacturing apparatus according to claim 1, characterized in that the removal means has a cleaning portion having a brush to be inserted between the upper and lower molds; a cleaner main body provided outside the mold means and including ultraviolet-ray supply means, ozone supply means, and ozone collecting means for collecting ozone and exhausted gases; wire means connected to the ultraviolet-ray supply means, each having an open tip portion in the cleaning portion; and pipe means connected to the ozone collecting means;

4. The semiconductor manufacturing apparatus according to claim 3, characterized in that the wire means connected to the ultraviolet-ray supply means is a glass fiber unit (21).

5. The semiconductor manufacturing apparatus according to claim 3, characterized in that the wire means connected to the ultraviolet-ray supply means has a plurality of wires, and the pipe means (22) onnected to the ozone supply means has a plurality of pipes, tip portions of the wires and the pipes being arranged in the vertical direction and in the horizontal direction such that ultraviolet rays and ozone can be uniformly applied to the surfaces of the upper and lower molds through the wires and the pipes.

6. A method of manufacturing a semiconductor device, characterized by comprising the steps of:
heating a mold unit consisting of upper and lower molds;
decomposing and removing dirt on the surfaces of the upper and lower molds by radiating ultraviolet rays in the atmosphere of heated ozone;
clamping the upper and lower molds after placing in the lower mold a lead frame having a semiconductor chip mounted thereon;
injecting a melted resin into the mold unit;
hardening the injected resin; and
dismounting the lead frame from the mold unit.

7. The method according to claim 6, characterized in that the heating step is performed at 150 - 200°C.

8. The method according to claim 6, characterized in that in the dirt decomposing/removing step, unnecessary resin accumulated on a parting surface of the mold unit is removed with a releasing agent adhered to the parting surface.

9. The method according to claim 6, characterized in that the dirt decomposing/removing step is performed by the use of cleaner means, which is inserted between the upper and lower molds and has ultraviolet-ray supply means, ozone supply means, ozone collecting means for collecting ozone and exhausted gases, and a movable brush to be brought into contact with the upper and lower molds.

10. The method according to claim 6, characterized in that the dirt decomposing/removing step is performed by the use of the dirt decomposing/removing means, which has a cleaning portion having a brush to be inserted between the upper and lower molds; a cleaner main body provided outside the mold means and including ultraviolet-ray supply means, ozone supply means, and ozone collecting means for collecting ozone and exhausted gases; wire means connected to the ultraviolet-ray supply means; pipe means connected to the ozone supply means; and pipe means connected to the ozone collecting means; the wire means and the two pipe means each having an opening tip portion in the cleaning portion.

11. The method according to claim 9, characterized in that heated ozone is supplied by means of the ozone supply means.

12. The semiconductor manufacturing apparatus according to claim 2 or 3, characterized in that the ozone supply means has heating means.
